## Europäisches Patentamt

## European Patent Office

## Office européen des brevets

(19)

(11) Veröffentlichungsnummer: **0 234 452**
**B1**

(12) # EUROPÄISCHE PATENTSCHRIFT

(45) Veröffentlichungstag der Patentschrift:
**19.09.90**

(51) Int. Cl.⁵: **H03H 17/02**

(21) Anmeldenummer: **87102072.3**

(22) Anmeldetag: **13.02.87**

(54) Digitale Schaltungsanordung zur Abtastratenänderung und Signalfilterung und Verfahren zu ihrem Entwurf.

(30) Priorität: **14.02.86 DE 3604602**

(43) Veröffentlichungstag der Anmeldung:
**02.09.87 Patentblatt 87/36**

(45) Bekanntmachung des Hinweises auf die Patenterteilung:
**19.09.90 Patentblatt 90/38**

(84) Benannte Vertragsstaaten:
**AT BE DE FR GB IT NL SE**

(56) Entgegenhaltungen:
**EP-A- 0 123 278**

**1982 INTERNATIONAL SYMPOSIUM ON CIRCUITS AND SYSTEMS, 10. - 12. Mai 1982, Rome, IT, Seiten 264-267, Band 2 von 3, IEEE; J.A. NOSSEK et al.: "Efficient sampling rate increase and decrease in wave digital filters with applications in communication systems"
000
IEEE TRANSACTIONS ON CIRCUITS AND SYSTEMS, Band CAS-29, Nr. 12, Dezember 1982, Seiten 797-806, IEEE; A. FETTWEIS et al.: "Sampling rate increase and decrease in wave digital filters"**

(73) Patentinhaber: **Siemens Aktiengesellschaft, Wittelsbacherplatz 2, D-8000 München 2(DE)**

(72) Erfinder: **Gazsi, Lajos, Dr., Faunastrasse 23, D-4000 Düsseldorf 1(DE)**

## Beschreibung

Die Erfindung betrifft eine digitale Schaltungsanordnung nach dem Oberbegriff des Patentanspruchs 1.

Digitale Systeme arbeiten oft mit unterschiedlichen Abtastraten, um die Anzahl der pro Sekunde auszuführenden Operationen zu reduzieren. Zur Verbindung der mit unterschiedlichen Abtastraten betriebenen Systemteile sind Abtastratenänderungen, d.h. Abtastratenerhöhungen oder - erniedrigungen notwendig. Jede Änderung der Abtastrate läßt sich in zwei Schritte zerlegen, nämlich in eine Abtastratenkompression oder- expansion und eine dezimierende oder interpolierende digitale Filterung, die eine ideale Tiefpaß- oder Bandpaß-Dämpfungscharakteristik approximiert.

In größeren, insbesondere Vielfachraten-Digitalsystemen werden die Dämpfungsspezifikationen oft durch vorausgehende Filterschritte erleichtert. Entsprechend kann der Abtastratenkompressor oder -expander mit einem digitalen Filter kombiniert werden, das andere Dämfpungsspezifikationen als reine dezimierende oder interpolierende Digitalfilter besitzt. In jedem Fall besteht das Problem darin, wirkungsvolle Möglichkeiten zur Kombination der beiden Schritte miteinander zu finden. Dabei ist es immer wünschenswert, daß das digitale Filter mit möglichst niedrigen Abtastraten betrieben wird, um den schaltungstechnischen und Bauelementeaufwand bzw. den Programmieraufwand möglichst klein zu halten.

In der Klasse der rekursiven Digitalfilter beschreibt die Veröffentlichung von A.Fettweis und J.A. Nossek "Sampling rate increase and decrease in wave digital filters", IEEE Trans. Circuits Syst., Vol. CAS-29, No. 12, 1982, pp. 797-806 die Verwendung eines Wellendigitalfilters mit Leiterstruktur in Verbindung mit einer Änderung der Abtastrate. Wellendigitalfilter entsprechen bei Analogfiltern passice LC- und Mikrowellenfilter und weisen die gleiche Stabilität auf. Außerdem besitzten sie eine sehr gute Empfindlichkeit bzw. eine hohe Toleranz. Die angegebene Anordnung weist einige Vorteile auf, insbesondere eine geringe Verlustleistung für eine gegebene Filterstruktur, einen großen Dynamikbereich und eine geringe Bandpaßempfindlichkeit für die Filterkoeffizienten. Allerdings arbeitet das gesamte Filter immer bei der höheren Abtastrate.

Aus der Veröffentlichung von A.Fettweis "Transmultiplexers with either analog conversion circuits, wave digital filters, or sc filters - A review", IEEE Trans. Communications, Vol. COM-30, No 7, 1982, pp. 1575-1586, ist bekannt, daß Wellendigitalfilter mit Gitterstruktur und bireziproker charakteristischer Funktion mit der halben sonst erforderlichen Abtastrate arbeiten können. Weiterhin ist aus dieser Literaturstelle bekannt, Pseudo-Mehrweg-Digitalfilter, Basis-Digitalfilter und Mittel zur Abtastratenänderung miteinander zu verknüpfen. Zum Verständnis der vorliegenden Erfindung wird der den bireziproken Digitalfiltern zugrundeliegende Gedanke nachfolgend kurz erläutert, wobei ausgehend von den Entwurfsprinzipien auf die bereits bekannte Filterstruktur eingegangen wird.

Beispielsweise ist angenommen, daß die Abtastratenänderung in einer Erhöhung der Abtastrate um den Faktor N bestehen soll. Zwischen jedes Abtastwertepaar einer Eingangsfolge von Abtastwerten werden dann vorzugsweise in äquidistanten Abständen N-1 Abtastwerte mit dem Wert 0 eingefügt, so daß sich die Ausgangsfolge aus den Abtastwerten der Eingangsfolge und den eingefügten Null-Abtastwerten ergibt. Es können N verschiedene Ausgangsfolgen existieren, die sich aus der Verzögerung einer Version der ausgangsfolge um jeweils einen Abtastzeitpunkt ergeben.

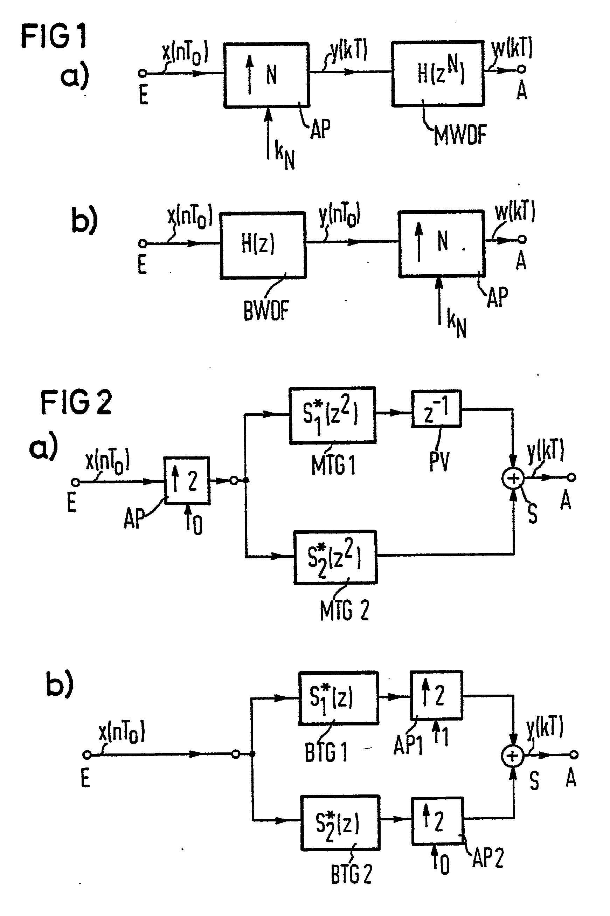

In dem Blockschaltbild gemäß Fig. 1 werden die Mittel zur Abtastratenänderung und zur Erzeugung einer Phasenänderung bzw. einer Verzögerungszeit durch den mit den Bezugszeichen AP bezeichneten Block symbolisiert, in dem der nach oben gerichtete Pfeil mit dem Bezugszeichen N die Abtastratenerhöhung um den Faktor N und der von unten in den Block AP führende Pfeil mit dem Bezugszeichen $k_N$ die Verzögerung der Ausgangsfolge um $k_N$ Abtastzeitpunkte darstellen. Man kann sich den Block AP auch durch ein Mittel zur Abtastratenänderung um den Faktor N ohne einen Phaseneffekt und nachfolgend eine in Serie geschaltete Anzahl von $k_N$ Verzögerungsgliedern für die höhere Abtastrate zusammengesetzt denken.

In Fig. 1a ist die am Eingang E anliegende Eingangsabtastfolge mit x $(nT_0)$ bezeichnet und die am Ausgang des Blocks AP anliegende Abtastfolge mit höher Abtastrate mit y (kT). Üblicherweise unterwirft man die zeitabhängigen Größen einer Zeit-Frequenz-Transformation, die bei digitalen Systemen als z-Transformation bekannt ist. X(z) und Y(z) sind die z-Transformierten der Größen x(nT) und y(kt) und z ist definiert als $z = e^{pT}$ mit der komplexen Konstanten p. In Fig. 1a ergibt sich für die z-transformierte Größe Y(z) am Ausgang des Blocks AP ein Zusammenhang nach Gleichung 1:

$$Y(z) = z^{-k_N} \cdot X(z^N) \; . \tag{1}$$

Der erste Faktor in Gleichung 1 gibt eine Verzögerung bzw. eine Phasenänderung an und der zweite Faktor der Gleichung 1 bezeichnet die für die höhere Abtastrate geltende z-Transformierte der Eingangs-Abtastfunktion x($nT_0$).

Gemäß Fig. 1a gelangt die Abtastfolge y(kT) mit der um den Faktor N erhöhten Abtastrate bzw. die z-Transformierte Y(z) anschließend zum Pseudo-Mehrweg-Digitalfilter MWDF, das die Transferfunktion

$H(z^N)$ besitzt. Am Ausgang A der Anordnung nach Fig. 1a liegt die gefilterte Abtastfolge $w(kT)$ mit der höheren Abtastrate. Im vorliegenden Ausführungsbeispiel handelt es sich bei dem Pseudo-Mehrweg-Digitalfilter MWDF um ein Pseudo-N-Weg-Digitalfilter. Derartige Filter sind unter anderem aus der Veröffentlichung von A. Fettweis, und H. Wupper, "A solution to the balancing problem in N-path filters", IEEE Trans. Circuit Theory, Vol. CT-18, 1971, pp. 403-405 bekannt. Man erhält das zum Pseudo-N-Weg-Digitalfilter gehörige Basisdigitalfilter dadurch, daß man die N-stufigen Schieberegister der Pseudo-N-Weg-Digitalfilter durch Verzögerungsglieder ersetzt. Das bedeutet, daß in der Transferfunktion $H(z^N)$ des Pseudo-N-Weg-Digitalfilters das Argument $z^N$ durch das Argument $z$ ersetzt werden muß, so daß sich für das Basis-Digitalfilter die Transferfunktion $H(z)$ ergibt.

Mit Gleichung 1 folgt unmittelbar, daß das Pseudo-N-Weg-Digitalfilter mit der Transferfunktion $H(z^N)$ als dessen Basis-Digitalfilter mit der Transferfunktion $H(z)$ ausgeführt sein kann, wenn die Reihenfolge der Abtastratenerhöhung und der digitalen Filterung vertauscht wird. Diese äquivalenten Ausführungsformen sind in Fig. 1 dargestellt, wobei in Fig. 1a die Eingangs-Abtastfolge zunächst einer Abtastratenerhöhung unterworfen und dann durch ein Pseudo-Mehrweg-Digitalfilter MWDF gefiltert wird, während in Fig. 1b die Eingangs-Abtastfolge zunächst im Basis-Digitalfilter BWDF gefiltert und anschließend einer Abtastratenerhöhung unterworfen wird. Gleiche Elemente sind in Fig. 1 mit gleichen Bezugszeichen versehen.

Fig. 2 zeigt ein Ausführungsbeispiel nach dem Stand der Technik (vgl. den oben genannten ersten IEEE Artikel) für eine digitale Schaltungsanordnung zur Abtastratenänderung und Signalfilterung und für ein Verfahren zu ihrem Entwurf. Die Abtastratenerhöhung soll um den Faktor 2 erfolgen und das digitale Filter ist ein Wellendigitalfilter mit Gitterstruktur und einer bireziproken charakteristischen Funktion. Beschriebt man das Übertrangungsverhalten der beiden Filterzweige des Filters durch die Reflektanzen $S_1$ und $S_2$, dann können bei der bekannten Anordnung mit bireziproker charakterischer Funkton die Transfergrößen der Filterzweige in der Form gemäß Gleichung 2 geschrieben werden:

$$S_1 = S_1^* (z^2) \cdot Z^{-1} \qquad (2a)$$
$$S_2 = S_2^* (z^2). \qquad (2b)$$

Eine Anordnung ist in Fig. 2a dargestellt. Im Signalweg ist hinter der Eingangsklemme E das Mittel AP zur Abtastratenänderung um den Faktor 2 ohne Erzeugung einer Phasenänderung angeordnet, dessen Ausgang auf die beiden Zweige des Wellendigitalfilters führt. Der obere Zweig des Wellendigitalfilters wird durch die Reflektanz $S_1$ bzw. die Pseudo-Mehrweg-Filterteilgruppe MTG 1 und die nachfolgende Phasenverzögerung PV und der untere Zweig des Wellendigitalfilters durch die Reflektanz $S_2$ bzw. die Pseudo-Mehrweg-Filterteilgruppe MTG 2 charakterisiert, wobei die Ausgänge beider Filterzweige auf einen Summierer S führen, der mit dem Ausgang A der Anordnung verbunden ist. Die Pseudo-Mehrweg-Filterteilgruppen MTG 1 und MTG 2 besitzen die Transferfunktionen $S_1^* (z^2)$ bzw. $S_2^* (z^2)$. Da beide Transferfunktionen von $z^2$ abhängen, kann die in Fig. 1 erläuterte Äquivalenz angewendet werden.

Fig. 2b zeigt die sich aus fig. 2a unter Berücksichtigung der Erläuterungen zu Fig. 1 ergebende Anordnung für eine Wellendigitalfilter mit Gitterstruktur und bireziproker charakterischer Funktion und eine Abtastratenerhöhung. Gegenüber Fig. 2a sind die Pseudo-Mehrweg-Filterteilgruppen MTG 1 und MTG 2 als deren Basis-Filterteilgruppen BTG 1 und BTG 2 mit den Transferfunktionen $S_1^* (z)$ und $S_2^* (z)$ ausgeführt. Beide Filterteilgruppen sind eingangsseitig direkt mit dem Eingang E der Schaltungsanordnung verbunden und arbeiten mit niedriger Abtastrate. Auf der Ausgangsseite der Filterteilgruppen BTG 1 und BTG 2 werden die Abtastraten mit Hilfe der Mittel AP 1 und AP 2 zur Abtastratenänderung um den Faktor 2 und zur Erzeugung einer Phasenänderung erhöht. Der Block AP 1 erzeugt gleichzeitig die Phasenänderung bzw. die Phasenverzögerung um eine Abtastrate, die gemäß Fig. 2a durch die Phasenverzögerung PV mit der Transferfunktion $z^{-1}$ vorgesehen ist. Entsprechend Fig. 2a werden die Ausgänge der Filterzweige in Fig. 2b auf den Summierer S geführt, der an den Ausgang A der Schaltungsanordnung angeschlossen ist.

Die beiden Mittel AP1 und AP2 zur Abtastratenänderung und Erzeugung einer Phasenänderung gemäß Fig. 2b arbeiten, d.h. fügen jeweils einen Nullwert zwischen zwei Abtastwerte in unterschiedlicher Ordnung ein, nämlich einmal mit einem Phasenfaktor 1 und einem Phasenfaktor 0. Deshalb kann die Ausgangsfolge $y(kT)$ in einfacher Weise durch Hin- und Herschalten zwischen den beiden Filterzweigen erhalten werden, so daß in diesem Ausführungsbeispiel der Summierer S eingespart werden kann.

Gemäß Fig. 2b arbeitet das gesamte Digitalfilter bei einer niedrigeren Abtastrate. Ein Nachteil dieser Anordnung ergibt sich jedoch aus der Tatsache, daß die charakteristische Funktion bireziprok sein muß. Für reale Frequenzen beträgt die Dämpfung immer 3,01 dB bei einem Viertel der Abtastfrequenz. Weiterhin kann der Dämpfungsverlauf in Abhängigkeit von der Frequenz nicht frei vorgegeben werden, weil die Filterkurve bereits durch eine Hälfte des Nyquist-Intervalls bestimmt wird und die andere Hälfte der Filterkurve sich mit Hilfe der Feldtkeller-Gleichung ergibt. Für viele Anwendungsfälle sind diese Symmetrieeigenschaften der bireziproken charakterisitischen Funktion unerwünscht.

Der Erfindung liegt die Aufgabe zugrunde, eine digitale Schaltungsanordnung zur Abtastratenänderung und Signalfilterung und ein Verfahren zu ihrem Entwurf anzugeben, bei dem zumindest Teile des digitalen Filters mit einer niedrigeren Abtastrate betrieben werden können, ohne daß sich charakteristische Beschränkungen für den Dämpfungsverlauf ergeben, bei der jedoch die vorzüglichen Eigenschaften hinsichtlich Stabilität und Empfindlichkeit von Wellendigitalfiltern mit Gitterstruktur erhalten bleiben.

Diese Aufgabe wird bei einer Schaltungsanordnung und einem Verfahren zu deren Entwurf erfindungsgemäß durch die Patentansprüche 1 und 10 gelöst.

Weitere Ausgestaltungen des Erfindungsgedankens sind in Unteransprüchen gekennzeichnet.

Die Erfindung wird im folgenden anhand von in den Figuren 3 bis 8 der Zeichnung dargestellten Ausführungsbeispielen näher erläutert. Dabei sind gleiche Elemente mit gleichen Bezugszeichen versehen. Es zeigt:

Fig. 3a ein Blockschaltbild eines Ausführungsbeispiels zum Entwurf eines Wellendigitalfilters mit Gitterstruktur und quasi-bireziproker charakteristischer Funktion ohne zusätzlichen Phasenfaktor in Verbindung mit einem Mittel zur Erhöhung der Abtastrate um den Faktor 2 und

Fig. 3b ein Blockschaltbild einer sich gemäß dem erfindungsgemäßen Verfahren und der Struktur nach Fig. 3a ergebenden erfindungsgemäßen Schaltungsanordnung,

Fig. 4a ein Blockschaltbild eines Ausführungsbeispiels eines Wellendigitalfilters mit Gitterstruktur und quasi-bireziproker charakteristischer Funktion und einem Phasenfaktor in Verbindung mit einem Mittel zur Erhöhung der Abtastrate um den Faktor 2,

Fig. 4b ein im Blockschaltbild einer gemäß dem erfindungsgemäßen Verfahren und der Struktur nach Fig. 4a sich ergebenden erfindungsgemäßen Schaltungsanordnung

Fig. 5a bis h Prinzipschaltbilder von Ausführungsbeispielen von in einer erfindungsgemäßen Schaltungsanordnung verwendeten Zweitor-Adaptoren für sinusförmige Anregung,

Fig. 6a ein Blockschaltbild eines Ausführungsbeispiels eines Wellendigitalfilters mit Gitterstruktur unter Einbeziehung der Zweitor-Adaptoren gemäß Fig.5,

Fig. 6b ein Blockschaltbild eines Ausführungsbeispiels eines PCM-Filters mit erfindungsgemäßer Schaltungsanordnung gemäß Fig. 3b,

Fig. 6c ein Diagramm des Dämpfungsverlaufs in Abhängigkeit keit von der Frequenz für ein optimiertes PCM-Filter gemäß Fig. 6c,

Fig. 7a ein Blockschaltbild eines Ausführungsbeispiels eines Wellendigitalfilters mit Gitterstruktur und quasi-bireziproker charakteristischer Funktion in Verbindung mit Mitteln zur Erhöhung und Erniedrigung der Abtastrate, im Ausführungsbeispiel ohne Phasenfaktor,

Fig. 7b ein Blockschaltbild einer gemäß dem erfindungsgemäßen Verfahren und einer Struktur gemäß Fig. 7a entworfenen erfindungsgemäßen Schaltungsanordnung,

Fig. 8a ein Blockschaltbild eines Ausführungsbeispiels eines optimierten Mehrfachraten-PCM-Wellendigitalfilters mit einer Erhöhung der Abtastrate um den Faktor 3 und

Fig. 8b ein Diagramm des Dämpfungsverlaufs in Abhängigkeit von der Frequenz für ein PCM-Filter gemäß Fig. 8a.

Die Erfindung geht davon aus, daß die das Übertragungsverhalten des digitalen Filters kennzeichnenden Transmittanzen, im Ausführungsbeispiel die Reflektanzen $S_1$ und $S_2$, sich in Produkte zerlegen lassen, deren Faktoren einerseits von $z^N$ und andererseits von z allein abhängen. Zusätzlich können Faktoren auftreten, die einen Phaseneffekt, d.h. eine Phasenverzögerung, beschreiben. Die Produktterme, die von $z^N$ abhängen und deren Transferfunktion somit ein Pseudo-N-Weg-Digitalfilter beschreibt, lassen sich dann durch ein Basis-Wellendigital-Teilfilter darstellen das mit niedrigerer Abtastrate betrieben wird, wie es dem bekannten Prinzip gemäß Fig. 1 entspricht. Erfindungsgemäß besitzt die Schaltungsanordnung zur Abtastratenänderung und zur Signalfilterung zwischen mindestens zwei Filterteilgruppen angeordnete Mittel zur Abtastratenänderung und zur Erzeugung einer Phasenänderung, deren Transferfunktionen den Faktoren des Produkts der Transmittanzen entsprechen, wobei die Pseudo-Mehrweg-Digitalfilterteilgruppen gemäß Fig. 1 als deren Basis-Filterteilgruppen ausgeführt sind.

Fig. 2 entsprechend wird in einem Ausführungsbeispiel angenommen, daß eine Abtastratenerhöhung um den Faktor 2 ohne Phaseneffekt vorgenommen werden soll und sich die Transmittanzen des Wellendigitalfilters mit Gitterstruktur durch die Reflektanzen $S_1$ und $S_2$ beschreiben lassen. Die Transmittanzen werden zunächst in Produkte gemäß Gleichung 3 faktorisiert:

$$S_1 = S_1' (z^2) \cdot S_1'' (z) \qquad\qquad (3a)$$
$$\text{oder } S_1 = S_1' (z^2) \cdot z^{-1} \cdot S_1'' (z) \qquad (3b)$$
$$S_2 = S_2' (z^2) \cdot S_2'' (z). \qquad\qquad (3c)$$

Gleichung 3 sagt aus, daß beide Transmittanzen $S_1$ und $S_2$ partielle Teile haben, die gerade in z sind, d.h. von $z^2$ abhängen. Gemäß den Ausführungen zu Fig. 1 können natürlich nur diese Teile des Filters mit einer niedrigeren Abtastrate arbeiten, wenn das Wellendigitalfilter mit dem Mittel zur Erhöhung der Abtastrate um den Faktor 2 kombiniert wird.

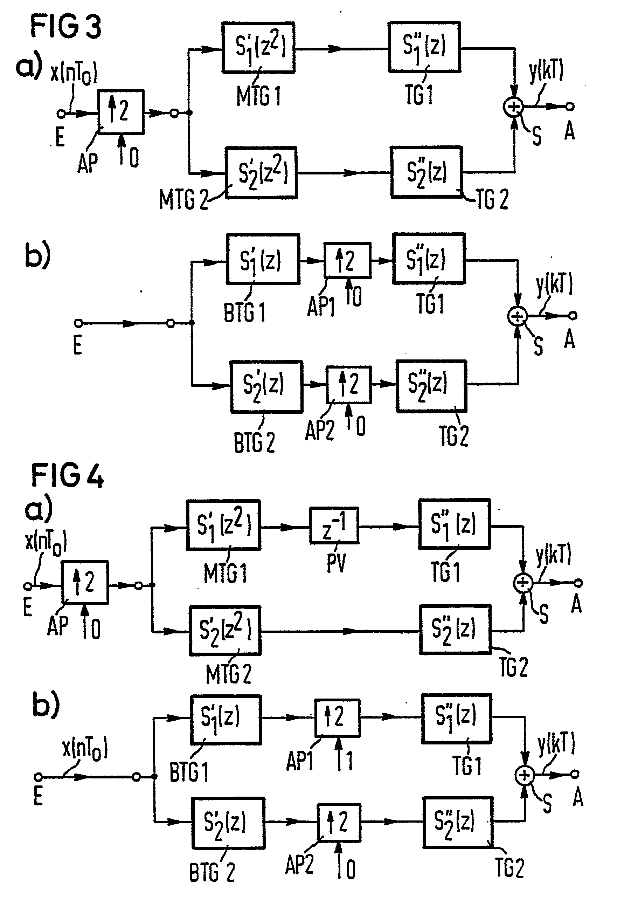

Ein Blockschaltbild eines Äusführungsbeispiels gemäß Gleichung 3a und Gleichung 3c ist in Fig. 3a dargestellt. Am Eingang E der Schaltungsanordnung liegt das Eingangssignal x $(nT_0)$ das im weiteren Signalweg zunächst zu dem Block AP gelangt, in dem die Abtastrate um den Faktor 2 erhöht wird. Das nachfolgende Wellendigitalfilter weist zwei Filterzweige auf, die jeweils eine Transferfunktion gemäß Gleichung 3a bzw. Gleichung 3c besitzen. Im ersten Filterzweig sind dazu hintereinander die Pseudo-Mehrfach-Filterteilgruppe MTG1 und die Filterteilgruppe TG1 mit den jeweiligen Transferfunktionen gemäß den Faktoren der Transmittanz $S_1$ nach Gleichung 3a angeordnet. Im zweiten Filterzweig sind die Pseudo-Mehrfach-Filterteilgruppe MTG2 und die Filterteilgruppe TG2 mit den jeweiligen Transferfunktionen gemäß den Faktoren der Transmittanz $S_2$ nach Gleichung 3c angeordnet. Mit Hilfe eines Summierers S werden die Signale der Filterzweige zum Ausgangssignal y (kT) summiert, das am Ausgang A der Schaltungsanordnung anliegt.

Gemäß den Ausführungen zu Fig. 1 können die Mittel zur Änderung der Abtastrate nun hinter die jeweils ersten Blöcke der Filterzweige "verschoben" werden, wenn diese Blöcke als Basis-Filterteilgruppen ausgeführt sind. Damit ergibt sich die erfidungsgemäße Struktur gemäß Fig. 3b. Die beiden Filterzweige sind direkt an den Eingang E angeschlossen und im Signalweg liegen im ersten Filterzweig zunächst die Basisfilterteilgruppe BTG1 mit der Transferfunktion $S_1'$ (z) sowie das Mittel AP1 zur Änderung der Abtastrate um den Faktor 2 und im zweiten Filterzweig die Basis-Filterteilgruppe BTG2 mit der Transferfunktion $S_2'$ (z) sowie das Mittel AP2 zur Änderung der Abtastrate um den Faktor 2. Die weiteren Blöcke der beiden Filterzweige, TG1 im ersten und TG2 im zweiten Filterzweig, sind wie in Fig. 3a direkt vor dem Summierer S angeordnet.

Fig. 4 zeigt ein Blockschaltbild eines Ausführungsbeispiels, bei dem die Transferfunktionen $S_1$ und $S_2$ der beiden Filterzweige gemäß den Gleichungen 3b und 3c faktorisiert werden. Im Unterschied zu Fig. 3a ist zwischen den beiden Blöcken MTG1 und TG1 ein Verzögerungsglied PV mit einer Transferfunktion $z^{-1}$ angeordnet. Die übrige Schaltungsanordnung entspricht Fig. 3a. Fig. 4b zeigt die erfindungsgemäße Schaltungsanordnung, bei der die Mittel AP zur Abtastratenänderung und Erzeugung einer Phasenänderung gemäß Fig. 1 in das digitale Filter "verschoben" werden, wobei dann die Pseudo-Mehrweg-Filterteilgruppen als Basis-Filterteilgruppen ausgeführt werden müssen. Gemäß Fig. 4b ergibt sich die gleiche Anordnung wie in Fig. 3b, mit dem Unterschied, daß im ersten Filterzweig das Mittel AP1 zur Abtastratenänderung und Erzeugung einer Phasenänderung eine Phasenänderung um eine Abtastrate bewirkt.

Für den Sonderfall, daß in den Filterteilgruppen TG1 und TG2 gemäß Fig. 4 die Transferfunktionen $S_1''$ (z) und $S_2''$ (z) jeweils gleich 1 sind, ergibt sich die bereits bekannte Struktur eines bireziproken Wellendigitalfilters gemäß Fig. 2.

Für beliebige Filterspezifikatinen müssen nach dem Stand der Technik entweder ein Wellendigitalfilter mit hoher Abtastfrequenz oder zwei kaskadierte Filter verwendet werden, wobei eines ein bireziprokes Wellendigitalfilter und das zweite ein Korrekturfilter ist.

Ein Vorteil der erfindungsgemäßen Schaltungsanordnung besteht darin, beliebige Filterspezifikation mit Hilfe des quasi-bireziproken Wellendigitalfilters realisieren zu können und gleichzeitig den schaltungstechnischen Aufwand, d.h. den Aufwand an Addierern, Multiplizierern und Speichern gegenüber den bekannten Filter- oder Schaltungsanordnungen zur reduzieren. Dabei arbeitet ein Teil des Filters mit niedriger, ein anderer mit hoher Abtastrate und die Änderung der Abtastrate erfolgt in den Filterzweigen selbst. Je größer bei der Faktorisierung gemäß Gleichung 3 bzw. gemäß den Fig. 3a und 4a die Anteile der Pseudo-Mehrweg-Filterteilgruppen MTG1 und MTG2 werden, d.h. je größer die Annäherung an ein bireziprokes Wellendigitalfilter ist, desto geringer ist der für die Schaltungsanordnung zu treibende Aufwand. Ein anderer Vorteil der erfindungsgemäßen Schaltungsanordnung liegt darin, daß der Geräuschspannungsabstand geringer als bei zwei kaskadierten Filtern ist.

Die Faktorisierung der Transferfunktionen bzw. der Transmittanzen gemäß Gleichung 3 bedeutet physikalisch keine Zerlegung der charakteristischen Funktion des Wellendigitalfilters in einen bireziproken Teil und einen allgemeinen Teil und umgekehrt. Darauf beruht die vorteilhafte Eigenschaft des Filters, keinen Einschränkungen hinsichtlich der Spezifikation unterworfen zu sein. Andererseits kann der Entwurf eines Filters mit Gitterstruktur und Transmittanzen der Form gemäß Gleichung 3 nicht einfach auf den Kriterien für einen Entwurf eines normalen oder bireziproken Filters beruhen. Die Erfindung umfaßt deshalb auch ein Verfahren zum Entwurf einer erfindungsgemäßen Schaltungsanordnung.

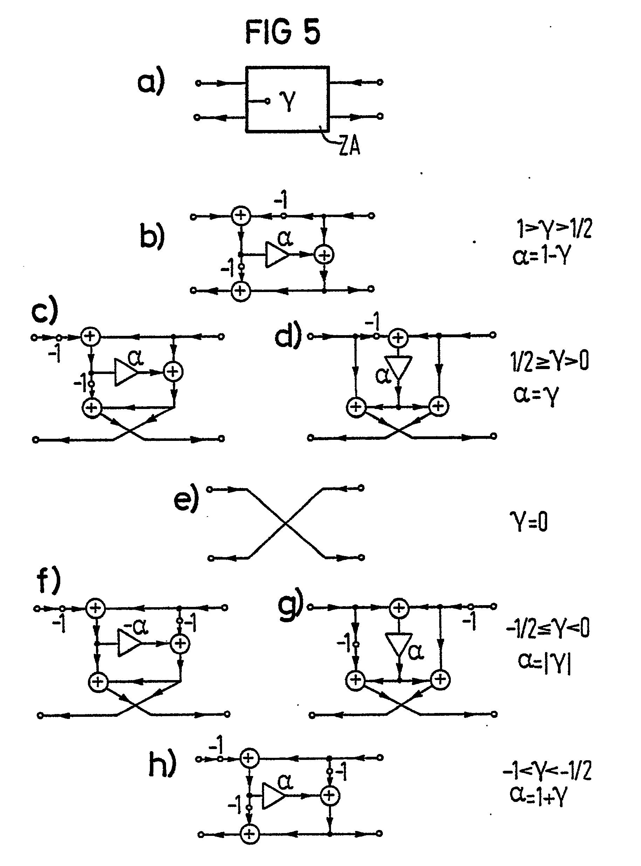

Fig. 5 zeigt Ausführungsbeispiele von für die Realisation eines Wellendigitalfilters benötigten Zweitor-Adaptoren. Fig. 5a gibt das Blockschaltbild eines Zweitor-Adaptors ZA an, das neben den jeweils zwei Klemmen eines Eingangs- und Ausgangstors eine weitere Klemme zur Einstellung eines das Übertragungsverhalten des Zweitor-Adaptors ZA wesentlich mitbestimmenden Koeffizienten $\gamma$ besitzt. Ein Zweitor-Adapator läßt sich gemäß Gleichung 4 definieren:

$$b_1 = \gamma \cdot (a_2 - a_1) + a_2 \qquad (4a)$$
$$b_2 = \gamma \cdot (a_2 - a_1) + a_1, \qquad (4b)$$

wo $a_1$, $a_2$ Eingangsgrößen; $b_1$, $b_2$ Ausgangsgrößen sind und $\gamma$ der Koeffizient ist. Die Zeichnungen der Fig. 5b bis 5h zeigen verschiedene Ausführungsformen von Signalflußdiagrammen, mit denen sich für jeweils verschiedene Wertebereiche von $\gamma$ bei sinusförmiger Anregung optimale Ergebnisse erzielen lassen. Gemäß Fig. 5e degeneriert ein Zweitor-Adaptor zu einer reinen Durchgangsverbindung, wenn der Koeffizient $\gamma$ zu 0 wird. Für eine Realisierung mit programmierbaren Signalprozessoren können Realisierungsformen von Zweitor-Adaptoren gemäß Gleichung 5 vorteilhafter sein:

$$b_1 = \beta \cdot a_2 - \gamma \cdot a_1 \qquad (5a)$$
$$b_2 = \gamma \cdot a_2 + \delta \cdot a_1, \qquad (5b)$$

wo $\beta = 1 + \gamma$ und $\delta = 1 - \gamma$.

Ein Wellendigitalfilter setzt sich aus mehreren Filterteilgruppen zusammen, die wiederum mehrere Filtergrundelemente umfassen. Ein Filtergrundelement wiederum besteht aus einem Zweitor-Addaptor gemäß Fig. 5 und aus einem Speicherelement, das eine Verzögerung bzw. einen Phasenffekt bewirkt. Der Grad des Filters wird durch die Anzahl der Zweitor-Addaptoren und der zugehörigen Speicherglieder bestimmt.

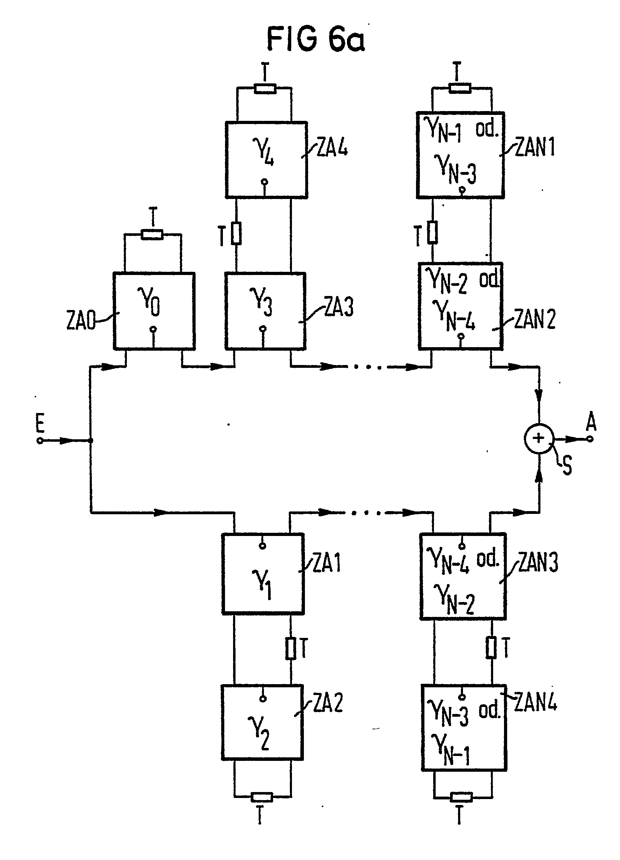

Beim Entwurf einer erfindungsgemäßen Schaltungsanordnung wird zunächst auf bekannte Art und Weise, beispielsweise mit Hilfe der Veröffentlichung von L. Gazsi, "Explicit formulae for lattice wave digital filters", IEEE Trans. Circuits and Systems Vol. CAS-32, No. 1, 1985, pp. 68-88, ein Wellendigitalfilter mit Gitterstruktur entworfen. Fig. 6a zeigt ein Blockschaltbild eines Ausführungsbeispiels eines derartigen Wellendigitalfilters. In beiden Filterzweigen sind jeweils mehrere Filterteilgruppen hintereinander geschaltet, die ihrerseits wieder aus Filtergrundelementen aus jeweils einem Zweitor-Adaptor ZA0 bis ZA4, ZAN1 bis ZAN4 und jeweils einem zugehörigen Verzögerungsglied T bestehen. Bei mehreren Filtergrundelementen in einer Filterteilgruppe sind die Grundelemente derart kaskadiert, daß jeweils ein Pol mindestens eines Tors jedes Zweitor-Adaptors ZA direkt und der andere Pol über ein Verzögerungsglied T mit den Polen eines Tors eines anderen Zweitor-Adaptors verbunden sind. Jede Filterteilgruppe enthält darüberhinaus mindestens einen Zweitor-Adaptor, bei dem das Verzögerungsglied T zwischen den Polen eines Tors angeschlossen ist.

Gemäß Fig. 6a enthält mit Ausnahme der ersten Filterteilgruppe aus dem Zweitor-Adaptor ZA0 und einem Verzögerungsglied T jede Filterteilgruppe 2 Zweitor-Adaptoren und zwei Verzögerungsglieder T, da im Ausführungsbeispiel gemäß den Fig. 3 und 4 die Abtastrate um den Faktor 2 erhöht werden soll. Allgemein ist es erforderlich, daß möglichst viele Filterteilgruppen die gleiche Anzahl an Filtergrundelementen enthält, die dem Faktor der Abtastratenänderung entspricht. Außerdem muß bei einem Entwurf gemäß Fig. 6a zur Gewährleistung eines ausreichend hohen Entwurfsspielraums der Filtergrad höher als der kleinstmögliche Filtergrad gewählt werden. Im nächsten Schritt werden dann bis auf einen die Koeffizienten $\gamma$ der in einer Filterteilgruppe kaskadierten Filtergrundelemente derart zu Null gewählt, daß eine dem Faktor der Abtastratenänderung entsprechende Zahl von Verzögerungsgliedern direkt hintereinander geschaltet sind. Dabei wird die Tatsache ausgenutzt, daß die Zweitor-Adaptor mit einem Koeffizienten $\gamma = 0$ eine Durchgangsverbindung darstellt.

Die Koeffizienten $\gamma_i, (i=0...N-1)$ sind jedoch im allgemeinen nicht gleich Null. Deshalb werden an sich für den Entwurf von Digitalfiltern bekannte Optimierungsverfahren für die Koeffizienten $\gamma_i$ eingesetzt und der verfügbare Entwurfsspielraum dazu benutzt, einige der Koeffizienten zu Null zu wählen. Eines dieser Verfahren ist beispielsweise aus der Veröffentlichung von K. Owenier, "Optimization of wave digital filters with reduced number of multipliers", Arch. Elektr.Übertr., vol. 30, 1976, pp. 387-393 bekannt. Das beschriebene Verfahren ist uneingeschränkt für den Entwurf einer erfindungsgemäßen Schaltungsanordnung einsetzbar.

Wenn die Anzahl der von Null verschiedenen Koeffizienten nicht größer als fünf beträgt, kann ein diskretes Optimierungsverfahren eingesetzt werden, aus dem direkt das endgültige quasi-bireziproke Wellendigitalfilter mit Gitterstruktur resultiert. Das diskrete Optimierungsverfahren ist aus der Veröffentlichung L. Gazsi, and S.N. Güllüoglu, "Discrete optimization of coefficients in CSD Code", Proc. IEEE Mediterranian Electrotechnical Conf., Athens, Greece, pp. C03.08/9, May 1983 bekannt.

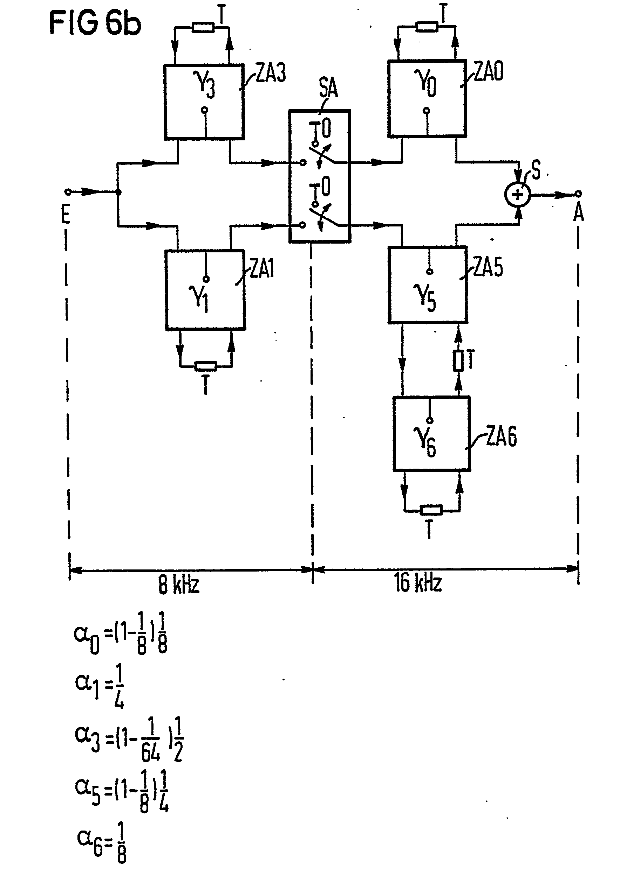

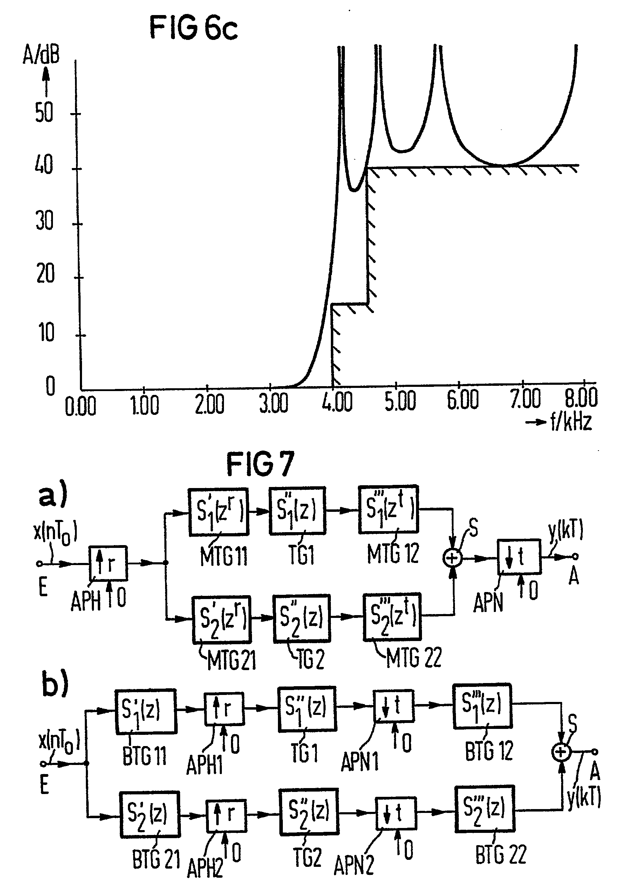

Mit Hilfe der Anordnung gemäß Fig. 6a soll im Ausführungsbeispiel der Fig. 6 eine erfindungsgemäße Schaltungsanordnung für ein PCM-System entworfen und angegeben werden. PCM-Übertragungsstrecken arbeiten mit einer Abtastrate von 8 kHz. Auf der Empfangs- bzw. Sendeseite muß der PCM-Code aufbereitet bzw. weiterverarbeitet werden. Beispielsweise wird der PCM-Code auf der Empfangsseite linearisiert und expandiert, d.h. die Abtastrate erhöht. Im Ausführungsbeispiel erfolgt die Filterung und Erhöhung der Abtastrate nach der Linearisierung des PCM-Codes. Als Spezifikation für das mit einer Abtastrate von 16 kHz arbeitende Tiefpaß-PCM-Filter ist der Dämpfungsverlauf in Abhängigkeit von der Frequenz vorgegeben. Dabei soll die Dämpfung unterhalb 3,4 kHz kleiner als 0,2 dB, oberhalb 4 kHz mindestens 15 dB und oberhalb 4,6 kHz mindestens 40 dB betragen. Zur Lösung dieser Aufgabe ist nach dem Stand der Technik ein nicht bireziprokes Wellendigitalfilter mit Gitterstruktur gemäß Fig. 6a erforderlich, das mindestens den Filtergrad 5 hat und mit hoher Abtastrate arbeitet.

Erfindungsgemäß wird nun bei einer Struktur gemäß Fig. 6a der Filtergrad höher als der niedrigstmögliche Grad, im Ausführungsbeispiel der Filtergrad 7 gewählt, d.h. es sind 7 Zweitor-Adaptoren und 7 Verzögerungsglieder T erforderlich. Gemäß Fig. 6a besteht die Möglichkeit, im ersten Filterzweig drei Filterteilgruppen und im zweiten Filterzweig eine Filterteilgruppe mit den Zweitor-Adaptoren ZA1 und ZA2 und deren Verzögerungsgliedern T anzuordnen. Im Ausführungsbeispiel sollen aber im ersten Filterzweig zwei Filterteilgruppen mit den Zweitor-Adaptoren ZA0, ZA3 und ZA4 und im zweiten Filterzweig ebenfalls zwei Filterteilgruppen mit den Zweitor-Adaptoren ZA1, ZA2, ZA5 und ZA6 angeordnet sein. Die Zweitor-Adaptoren ZA5 und ZA6 entstehen dabei durch Umbenennung aus den Zweitor-Adaptoren ZAN3 und ZAN4.

Da der niedrigstmögliche Filtergrad 5 beträgt, werden beim Einsatz des ersten der zuvor beschriebenen Optimierungsverfahren nunmehr zwei der Koeffizienten zu Null gewählt im Ausführungsbeispiel die Koeffizienten $\gamma_2$ und $\gamma_4$. Die Zweitor-Adaptoren ZA2 und ZA4 stellen dann Durchgangsverbindungen

EP 0 234 452 B1

dar, so daß in den zugehörigen Filterteilgruppen jeweils zwei Verzögerungsglieder T direkt hintereinander geschaltet sind.

Aufgrund der Aufgabe der Verzögerungsglieder, ein an ihrem Eingang anstehendes Signal um eine Abtastrate zu verzögern, werden die Eingangssignale zweier hintereinandergeschalteter Verzögerungsglieder um zwei Abtastraten verzögert, ohne daß eine weitere Operation durchgeführt wird. Konsequenterweise können die Zweitor-Adaptoren ZA1 und ZA3, die zu den Koeffizienten $\gamma_1$ und $\gamma_3$ gehören, nunmehr unter Einsparung jeweils eines Verzögerungsgliedes T mit niedrigerer Abtastrate betrieben werden.

In der Anordnung gemäß Fig. 6a werden die Filterteilgruppen mit dem Zweitor-Adaptoren ZA1 und ZA3 in jedem Filterzweig direkt hinter der Eingangsklemme E, d.h. die Filterteilgruppe mit dem Zwseitor-Adaptor ZA0 im Signalweg weiter hinten angeordnet. Sodann können die Mittel zur Änderung der Abtastrate, im Ausführungsbeispiel eine Schaltanordnung SA, die zwischen zwei am Eingang E anliegenden Abtastwerten einen Nullwert einfügt, in das Filter "verschoben" werden.

Die mit Hilfe des erfindungsgemäßen Entwurfsverfahrens entstandene erfindungsgemäße Schaltungsanordnung zeigt Fig. 6b. Die Abtastrate in jedem Filterzweig wird mit Hilfe der Schaltanordnung SA um den Faktor 2 erhöht, so daß der erste Teil des Filters mit dem Zweitor-Adaptoren ZA1 und ZA3 und deren Verzögerungsgliedern T mit niedriger Abtastrate von 8 kHz und der zweite Teil des Filters mit der hohen Abtastrate von 16 kHz arbeitet. Zusätzlich sind in Fig. 6b die optimierten Koeffizienten $\alpha$ angegeben, die gemäß Fig. 5 zu den Koeffizienten $\gamma$ der Zweitor-Adaptoren in Beziehung stehen.

Es gehört in den Rahmen der Erfindung, daß auch in dem mit höherer Abtastrate arbeitenden zweiten Teil des Filters Vereinfachungen vorgenommen werden können, d.h. daß unter Umständen einzelne Elemente mit niedrigerer Abtastrate betrieben werden können und folglich vor dem Eingang der Schaltanordnung SA angeordnet sein können. Im Ausführungsbeispiel betreffen diese Maßnahmen beispielsweise die Eingangsaddierer bzw. Eingangssubstrahierer der Zweitor-Adaptoren ZA0 und ZA5, da gemäß Fig. 6b die Schalter der Schaltanordnung SA zu jedem zweiten Abtastzeitpunkt Nullwerte in die beiden Zweitor-Adaptoren einspeisen.

Fig. 6c zeigt den Dämpfungsverlauf in Abhängigkeit von der Frequenz für die erfindungsgemäß optimierte erfindungsgemäße Schaltungsanordnung. Während unterhalb 3,4 kHz die Dämpfung kleiner 0,2 dB ist beträgt die Dämpfung bei 4 kHz deutlich mehr als die vorgeschriebenen 15 dB.

Dieselben erfindungsgemäßen Entwurfskriterien lassen sich auch für eine Anordnung zur Erniedrigung der Abtastrate herbeiziehen, wenn man nur die Modifikationen anwendet, die in dem Aufsatz von T.A.C.M. Claasen und W.F.G. Mecklenbräuker, "On the transposition of linear time-varying discretetime networks and its application to mutirate digital systems", Philips I. Res., vol. 33, 1978, pp. 78-102 beschrieben sind. Erfindungsgemäß ergeben sich dann Blockschaltbilder gemäß Fig. 3b und Fig. 4b mit dem Unterschied, daß in jedem Filterzweig die Blöcke mit den Basis-Filterteilgruppen BTG und den Filterteilgruppen TG vertauscht werden und die Mittel AP zur Änderung der Abtastrate eine Erniedrigung der Abtastrate durchführen. Bei einer derartigen Anordnung zur Abtastratenerniedrigung sind somit die mit niedrigerer Abtastrate betriebenen Filterteilgruppen vor dem Summierer S der Schaltungsanordnung angeordnet.

Mit Hilfe des erfindungsgemäßen Entwurfsverfahren ist gleichfalls der Entwurf einer Schaltungsanordnung möglich, bei der ein Wellendigitalfilter mit Mitteln zur Erhöhung und Erniedrigung der Abtastrate kombiniert wird, sogenannte Vielfachraten-Abtastsyteme. Fig. 7a zeigt ein Blockschaltbild eines Ausführungsbeispiels, bei dem im Signalweg hinter dem Eingang E der Schaltungsanordnung ein Mittel APH zur Erhöhung der Abtastrate um den Faktor r, anschließend ein Wellendigitalfilter mit Gitterstruktur mit seinen beiden Filterzweigen, deren Ausgänge auf einen Summierer S führen, und zwischen dem Ausgang des Summierers S und der Ausgangsklemme A ein Mittel APN zur Erniedrigung de Abtastrate um den Faktor t angeordnet is. Zwischen der Eingangsklemme E und der Ausgangsklemme A der Schaltungsanordnung wird die Abtastrate somit um den Bruch r geteilt durch t geändert, wobei r und t ganze Zahlen sind.

Erfindungsgemäß werden nun wiederum die Transferfunktionen, d.h. die Transmittanzen $S_1$ und $S_2$ der Filterzweige faktorisiert, so daß sich Pseudo-r-Weg-und Pseudo-t-Weg-Filterteilgruppen sowie Filterteilgruppen bei der Realisierung ergeben. Erfindungsgemäß werden dann die Pseudo-r-Weg Filterteilgruppen MTG11 und MTG21 als Basis-Filterteilgrup-pen BTG11 und BTG21 und die Pseudo-t-Weg-Filterteilgruppen MTG12 und MTG22 als Basis-Filterteilgruppen BTG12 und BTG22 unter Einsatz eines der zuvor beschriebenen Optimierungsverfahren ausgeführt. Gleichzeitig werden die MIttel APH zur Erhöhung und APN zur Erniedrigung der Abtastrate von der Eingangsklemme E bzw. der Ausgangsklemme A über die Basis-Filterteilgruppen in das Filter "verschoben".

Die dann entstandene erfindungsgemäße Schaltungsanordnung zeigt Fig. 7b. Der erste Zweig der Schaltungsanorndung enthält in dem Signalweg die Blöcke BTG11, APH1, TG1, APN1, und BTG12, der zweite Zweig der Schaltungsanorndung die Blöcke BTG21, APH2, TG2, APN2 und BTG22. Gemäß der Erfindung arbeitet der erste Teil der Schaltungsanorndung mit der an der Eingangsklemme E ankommenden niedrigeren Abtastrate, der zweite Teil, d.h. die Filterteilgruppen TG1 und TG2, mit der um den Faktor r erhöhten Abtastrate und der dritte Teil, d.h. die Basis-Filterteilgruppen BTG12 und BTG22 und der Summierer S mit der um den Faktor t erniedrigten Abtastrate.

Das erfindungsgemäße Verfahren zum Schaltungsentwurf läßt sich für diese Vielfachraten-Abtast-

7

systeme genauso anwenden, wie bei Systemen, bei denen die Abtastrate allein um einen einzigen Faktor geändert wird.

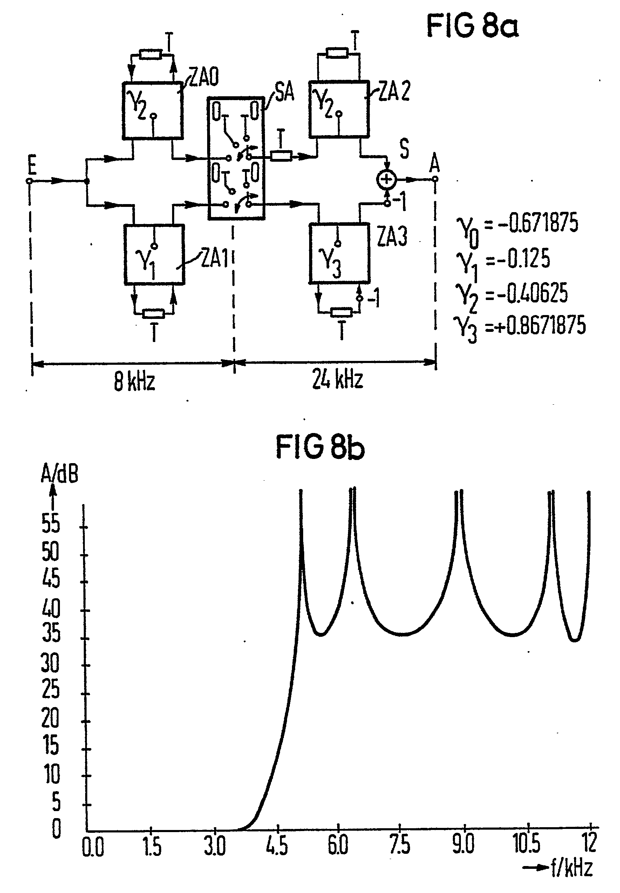

Fig. 8 zeigt deshalb ein Ausführungsbeispiel eines erfindungsgemäßen PCM-Vielfachraten-Wellendigitalfilters, bei dem der Faktor r gleich 3 und t gleich 1 ist, d.h. bei dem die Abtastrate um den Faktor 3 erhöht wird. Fig. 8a zeigt das Blockschaltbild der Anordnung, bei dem die Filterteilgruppen mit den Zweitor-Adaptoren ZA0 und ZA1 sowie deren Verzögerungsglieder T mit der niedrigen Abtastrate von 8 kHz und die Filterteilgruppen mit den Zweitor-Adaptoren ZA2 und ZA3, deren Verzögerungsglieder, der Summierer S sowie ein Verzögerungsglied T im ersten Filterzweig vor dem Eingang des Zweitor-Adaptors ZA2 mit einer Abtastrate von 24 kHz betrieben werden. Die beiden Schalter der Schaltanordnung S fügen dabei zwischen jeweils zwei Abtastwerte der am Eingang E anliegenden Folge jeweils zwei Nullwerte ein. Fig. 8a gibt gleichzeitig optimale Werte für die γ-Koeffizienten der Zweitor-Adaptoren an, mit denen sich der in Fig. 8b gezeigte Verlauf der Dämpfung in Abhängigkeit von der Frequenz ergibt.

## Patentansprüche

1. Digitale Schaltungsanordnung zur Abtastratenänderung und zur Signalfilterung mit einem Eingang (E) und einem Ausgang (A), mit Mitteln (AP, APH, APN) zur Abtastratenänderung und zur Erzeugung einer Phasenänderung in einem digitalen System sowie mit einem Wellendigitalfilter in Gitterstruktur mit mehreren, insbesondere zwei Filterzweigen, die mit dem Eingang (E) und über einen Summierer (S) mit dem Ausgang (A) verbunden sind, wobei die Filterzweige Filterteilgruppen (MTG, BTG, TG) mit Filtergrundelementen aus jeweils einem aus Summierern (+) und Multiplizierern ( $\alpha,\gamma$ ) aufgebauten Zweitor-Adaptor (ZA) und einem Verzögerungsglied (T) aufweisen, **dadurch gekennzeichnet**, daß jeder Filterzweig mindestens zwei in Serie liegende Filterteilgruppen (BTG, TG) enthält, zwischen denen die Mittel (AP1, AP2; APH1, APH2, APN1, APN2) zur Abtastratenänderung und zur Erzeugung einer Phasenänderung angeordnet sind.

2. Anordnung nach Anspruch 1, **dadurch gekennzeichnet**, daß die Mittel (AP) zur Abtastratenänderung die Abtastrate jeweils um einen ganzzahligen Faktor erhöhen (r) oder erniedrigen (t).

3. Anordnung nach Anspruch 1 oder 2, **dadurch gekennzeichnet**, daß mehrere Filtergrundelemente (ZA,T) in einer Filterteilgruppe derart kaskadiert sind, daß jeweils ein Pol mindestens eines Tors jedes Zweitor-Adaptors (ZA) direkt und der andere Pol über ein Verzögerungsglied (T) mit den Polen eines Tors eines anderen Zweitor-Adaptors (ZA) verbunden sind.

4. Anordnung nach Anspruch 1 bis 3, **dadurch gekennzeichnet**, daß die Filterteilgruppen eine Basis-Filterteilgruppe (BTG) aus einem Zweitor-Adaptor (ZA) und einem zwischen einem Tor angeordneten Verzögerungsglied (T) enthalten.

5. Anordnung nach Anspruch 1 bis 4, **dadurch gekennzeichnet**, daß Zweitor-Adaptoren (ZA) mit einem Multiplikationskoeffizienten γ = 0 der Multiplizierer ( $\alpha,\gamma$ ) Durchgangsverbindungen realisieren.

6. Anordnung nach Anspruch 1 bis 5, **dadurch gekennzeichnet**, daß eine Anzahl der Filterteilgruppen als Basis-Filterteilgruppen (BTG) von Pseudo-Mehrweg-Filterteilgruppen (MTG) ausgeführt sind, deren Pseudo-Mehrweg-Filtergerade (r, t) den ganzzahligen Faktoren (r, t) der Abtastratenänderung entsprechen.

7. Anordnung nach Anspruch 1 bis 6, **dadurch gekennzeichnet**, daß die Basis-Filterteilgruppen (BTG) der zugeordneten Pseudo-Mehrweg-Filterteilgruppen (MTG) im Signalweg bei einer Abtastratenerhöhung hinter dem Eingang (E) der Anordnung und bei einer Abtastratenerniedrigung vor dem Summierer (S) angeordnet sind.

8. Anordnung nach Anspruch 1 bis 7, **dadurch gekennzeichnet**, daß die Mittel zur Abtastratenänderung und zur Erzeugung einer Phasenänderung (AP1, AP2; APH1, APH2, APN1, APN2) im Signalweg der Anordnung bei einer Abtastratenerhöhung direkt hinter und bei einer Abtastratenerniedrigung direkt vor den Basis-Filterteilgruppen (BTG1, BTG2; BTG11, BTG21, BTG12, BTG22) der zugeordneten Pseudo-Mehrweg-Filterteilgruppen (MTG) angeordnet sind und daß diese mit jeweils niedrigerer Abtastrate betrieben werden.

9. Anordnung nach Anspruch 1 bis 7, **gekennzeichnet** sowohl durch eine Abtastratenerhöhung als auch durch eine Abtastratenerniedrigung.

10. Verfahren zum Entwurf einer Anordnung nach Anspruch 1 bis 9 mit Hilfe an sich bekannter Optimierungsverfahren, dadurch gekennzeichnet, daß zunächst ein Wellendigitalfilter mit einem höheren als dem kleinstmöglichen Filtergrad mit einer Struktur eines Gitter-Wellendigitalfilters entworfen wird, bei dem die Mittel (AP) zur Abtastratenänderung und zur Erzeugung einer Phasenänderung im Signalweg bei einer Abtastratenerhöhung vor und bei einer Abtastratenerniedrigung hinter dem Wellendigitalfilter liegen und bei dem in den Filterzweigen in Serie liegende Filterteilgruppen mit Pseudo-Mehrweg-Filterteilgruppen (MTG) enthalten sind, die eine dem ganzzahligen Faktor (r, t) der Abtastratenänderung entsprechende Zahl an Filtergrundelementen (ZA, T) aufweisen, daß unter Anwendung eines der Optimierungsverfahren bis auf einen die Multiplikationskoeffizienten ($\alpha$, $\gamma$) der Filtergrundelemente (ZA, T) zumindest eines Teils der Pseudo-Mehrweg-Filterteilgruppen (MTG) zu Null bestimmt werden und diese Pseudo-Mehrweg-Filterteilgruppen (MTG) im Signalweg bei einer Abtastratenerhöhung direkt hinter dem Mittel (AP; APH, APN) zur Erhöhung der Abtastrate und zur Erzeugung einer Phasenänderung und bei einer Abtastratenerniedrigung direkt vor dem Summierer (S) angeordnet werden,

daß diese Pseudo-Mehrweg-Filterteilgruppen (MTG) durch ihre Basis-Filtergruppen (BTG) ausgebildet werden und gleichzeitig die Mittel zur Abtastratenänderung und zur Erzeugung einer Phasenänderung (AP; APH, APN) gemäß den kennzeichnenden Merkmalen des Anspruchs 1 angeordnet werden.

11. Verfahren nach Anspruch 10, **gekennzeichnet**, durch Anwendung eines an sich bekannten diskreten Optimierungsverfahrens auf ein Wellendigitalfilter mit weniger als sechs von Null verschiedenen Multiplikationskoeffizienten ($\alpha,\gamma$) der Filtergrundelemente (ZA, T).

## Claims

1. Digital circuit arrangement for sampling rate variation and for signal filtering, having an input (E) and an output (A), having means (AP, APH, APN) for sampling rate variation and for generating a phase change in a digital system, and also having a wave digital filter in lattice structure with a plurality of, preferably two, filter branches which are connected to the input (E) and, via an adder (S), to the output (A), the filter branches having filter subgroups (MTG, BTG, TG) with basic filter elements each comprising a two-port adaptor (ZA) constructed of adders (+) and multipliers (a, g) and a time-lag element (T), characterized in that each filter branch contains at least two series-connected filter subgroups (BTG, TG), between which the means (AP1, AP2; APH1, APH2, APN1, APN2) for sampling rate variation and for generating a phase change are disposed.

2. Arrangement according to Claim 1, characterized in that the means (AP) for sampling rate variation increase (r) or decrease (t) the sampling rate by an integral factor in each case.

3. Arrangement according to Claim 1 or 2, characterized in that a plurality of basic filter elements (ZA, T) are cascaded in a filter subgroup in such a way that in each case one pole of at least one port of each two-port adaptor (ZA) is directly connected and the other pole is connected via a time-lag element (T) to the poles of a port of another two-port adaptor (ZA).

4. Arrangement according to Claim 1 to 3, characterized in that the filter subgroups contain a basic filter subgroup (BTG) comprising a two-port adaptor (ZA) and a time-lag element (T) disposed between one port.

5. Arrangement according to Claim 1 to 4, characterized in that two-port adaptors (ZA) realize through-connections with a multiplication coefficient $\alpha = O$ of the multipliers ($\alpha$, $\gamma$).

6. Arrangement according to Claim 1 to 5, characterized in that a number of the filter subgroups are designed as basic filter subgroups (BTG) of pseudomultiple-path filter subgroups (MTG), the pseudomultiplepath filter degrees (r, t) of which correspond to the integral factors (r, t) of the sampling rate variation.

7. Arrangement according to Claim 1 to 6, characterized in that the basic filter subgroups (BTG) of the associated pseudo-multiple-path filter subgroups (MTG) are disposed in the signal path downstream of the input (E) of the arrangement in the case of a sampling rate increase, and upstream of the adder (S) in the case of a sampling rate decrease.

8. Arrangement according to Claim 1 to 7, characterized in that the means for sampling rate variation and for generating a phase change (AP1, AP2; APH1, APH2, APN1, APN2) are disposed in the signal path of the arrangement directly dowstream, in the case of a sampling rate increase, and directly upstream, in the case of a sampling rate decrease, of the basic filter subgroups (BTG1, BTG2; BTG11, BTG21, BTG12, BTG22) of the associated pseudo-multiple-path filter subgroups (MTG), and in that the latter are operated at a lower sampling rate in each case.

9. Arrangement according to Claim 1 to 7, characterized both by a sampling rate increase and by a sampling rate decrease.

10. Method for designing an arrangement according to Claim 1 to 9 with the aid of optimizing methods known per se, characterized in that first of all a wave digital filter having a filter degree higher than the minimum possible and having a structure of a lattice wave digital filter is designed, in which the means (AP) for sampling rate variation and for generating a phase change in the signal path lie upstream, in the case of a sampling rate increase, and downstream, in the case of a sampling rate decrease, of the wave digital filter, and in which filter branches contain series-connected filter subgroups with pseudo-multiple-path filter subgroups (MTG), which contain a number of basic filter elements (ZA, T) corresponding to the integral factor (r, t) of the sampling rate variation, in that, using one of the optimization methods, all but one of the multiplication coefficients ($\alpha$, $\gamma$) of the basic filter elements (ZA, T) of at least a part of the pseudo-multiple-path filter subgroups (MTG) are set to zero, and said pseudo-multiplepath filter subgroups (MTG) are disposed in the signal path, in the case of a sampling rate increase, directly downstream of the means (AP; APH, APN) for increasing the sampling rate and for generating a phase change, and are disposed directly upstream of the adder (S) in the case of a sampling rate decrease, and in that these pseudomultiple-path filter subgroups (MTG) are formed by their basic filter groups (BTG) and at the same time the means for sampling rate variation and for generating a phase change (AP; APH, APN) are disposed in accordance with the characterizing features of Claim 1.

11. Method according to Claim 10, characterized by the use of a discrete optimization method know per se for a wave digital filter having fewer than six multiplication coefficients ($\alpha$, $\gamma$) of the basic filter elements (ZA, T) that differ from zero.

**Revendications**

1. Montage numérique servant à modifier une cadence d'échantillonnage et à filtrer des signaux, comportant une entrée (E) et une sortie (A), des moyens (AP, APH, APN) servant à modifier la cadence d'échantillonnage et à produire une modification de la phase dans un système numérique, ainsi qu'un filtre d'ondes numérique possédant une structure de grille comportant plusieurs et notamment deux branches, qui sont reliées à l'entrée (E) et par l'intermédiaire d'un additionneur (S) à la sortie (A), les branches du filtre contenant des groupes partiels de filtrage (MTG, BTG, TG) contenant des éléments de base de filtre constitués respectivement par un adaptateur (ZA) à deux portes, constitué par des additionneurs (+) et par des multiplicateurs ($\alpha$, $\gamma$), et par un circuit de retardement (T), caractérisé par le fait que chaque branche du filtre contient au moins deux groupes partiels de filtrage (BTG, TG) branchés en série et entre lesquels sont branchés les moyens (AP1, AP2; APH1, APH2, APN1, APN2) servant à modifier la cadence d'échantillonnage et à produire un déphasage.

2. Dispositif suivant la revendication 1, caractérisé par le fait que les moyens (AP) servant à modifier la cadence d'échantillonnage augmentent (r) ou réduisent (t) la cadence d'échantillonnage, respectivement d'un facteur égal à un multiple entier.

3. Dispositif suivant la revendication 1 ou 2, caractérisé par le fait que plusieurs éléments de base de filtre (ZA, T) situés dans un groupe partiel de filtrage sont branchés en cascade, que respectivement un pôle d'au moins une porte de chaque adaptateur (ZA) à deux portes est raccordé directement, et l'autre pôle par l'intermédiaire d'un circuit de raccordement (T) aux pôles d'une porte d'un autre adaptateur (ZA) à deux portes.

4. Dispositif suivant les revendications 1 à 3, caractérisé par le fait que les groupes partiels de filtrage contiennent un groupe partiel de filtrage de base (BTG) formé par un adaptateur (ZA) à deux portes et par un circuit de retardement (T) disposé entre des adaptateurs.

5. Dispositif suivant les revendications 1 à 4, caractérisé par le fait que des adaptateurs (ZA) à deux portes réalisent des liaisons de transmission avec un coefficient multiplicateur $\gamma$=O pour les multiplicateurs ($\alpha$, $\gamma$).

6. Dispositif suivant les revendications 1 à 5, caractérisé par le fait qu'un certain nombre des groupes partiels de filtrage sont réalisés sous la forme de groupes partiels de filtrage de base (BTG) de pseudo-groupes partiels de filtrage à voies multiples (MTG), dont les degrés (r, t) correspondent aux facteurs (r, t), formés de multiples entiers, de la modification de la cadence d'échantillonnage.

7. Dispositif suivant les revendications 1 à 6, caractérisé par le fait que les groupes partiels de filtrage de base (BTG) des pseudo-groupes partiels de filtrage à voies multiples (MTG), associés, sont disposés dans la voie de transmission des signaux, en aval de l'entrée (E) du dispositif dans le cas d'un accroissement de la cadence d'échantillonnage et en amont de l'additionneur (S) dans le cas d'une réduction de la cadence d'échantillonnage.

8. Dispositif suivant les revendications 1 à 7, caractérisé par le fait que les moyens (AP1, AP2; APH1, APH2, APN1, APN2) servant à modifier la cadence d'échantillonnage et à produire une modification de la phase sont placés dans la voie de transmission des signaux du dispositif, directement en aval, dans le cas d'un accroissement de la cadence d'échantillonnage, et directement en amont, dans le cas d'une réduction de la cadence d'échantillonnage, des groupes partiels de filtrage de base (BTG1, BTG2; BTG11, BTG21, BTG12, BTG22) des pseudo-groupes partiels de filtrage à voies multiples (MTG), associés, et que ces moyens fonctionnent avec la cadence d'échantillonnage respectivement réduite.

9. Dispositif suivant les revendications 1 à 7, caractérisé par aussi bien un accroissement de la cadence d'échantillonnage qu'une réduction de la cadence d'échantillonnage.

10. Procédé pour développer un dispositif suivant les revendications 1 à 9 à l'aide d'un procédé d'optimisation connu en soi, caractérisé par le fait que l'on développe tout d'abord un filtre d'ondes numérique possédant un degré supérieur au degré de filtre le plus faible possible, avec une structure de filtre d'ondes numérique en forme de grille,
les moyens (AP) servant à modifier la cadence d'échantillonnage et à produire une modification de la phase étant situés dans le trajet de transmission des signaux en amont du filtre d'ondes numérique dans le cas d'un accroissement de la cadence d'échantillonnage et en aval de ce filtre dans le cas d'une réduction de la cadence d'échantillonnage, et
des groupes partiels de filtrage branchés en série dans les branches du filtre contenant des pseudo-groupes partiels de filtrage à voies multiples (MTG), qui possèdent un nombre d'éléments de base de filtre (ZA, T), qui correspond au facteur (r, t), formé d'un nombre entier, de la modification de la cadence d'échantillonnage,
que dans le cas de l'application de l'un des procédés d'optimisation, les coefficients multiplicateurs ($\alpha$, $\gamma$) des éléments de base de filtre (ZA, T) d'au moins une partie des pseudo-groupes partiels de filtrage à voies multiples (MTG) sont réglés à zéro, sauf un, et que ces pseudo-groupes partiels de filtrage à voies multiples (MTG) sont disposés dans la voie de transmission des signaux, directement en aval des moyens (AP; APH, APN) servant à accroître la cadence d'échantillonnage et à produire une modification de la phase, dans le cas d'un accroissement de la cadence d'échantillonnage, et directement en amont de l'additionneur (S), dans le cas d'une réduction de la cadence d'échantillonnage,

que ces pseudo-groupes partiels de filtrage à voies multiples (MTG) sont formés par leurs groupes de filtrage de base (BTG) et que les moyens (AP; APH, APN) servant à modifier la cadence d'échantillonnage et à produire une modification de la phase sont disposés conformément aux éléments caractéristiques de la revendication 1.

11. Procédé suivant la revendication 10, caractérisé par la mise en oeuvre d'un procédé d'optimisation discret connu en soi dans un filtre d'ondes numérique, pour lequel moins de six coefficients multiplicateurs ($\alpha$, $\gamma$) des éléments de base de filtre (ZA, T) sont différents de zéro.

FIG 1

a)

b)

FIG 2

a)

b)

# FIG 3

**a)**

**b)**

# FIG 4

**a)**

**b)**

EP 0 234 452 B1

# FIG 5

# FIG 6a

# FIG 6b

$$\alpha_0 = (1 - \tfrac{1}{8})\tfrac{1}{8}$$

$$\alpha_1 = \tfrac{1}{4}$$

$$\alpha_3 = (1 - \tfrac{1}{64})\tfrac{1}{2}$$

$$\alpha_5 = (1 - \tfrac{1}{8})\tfrac{1}{4}$$

$$\alpha_6 = \tfrac{1}{8}$$

# FIG 6c

# FIG 7

a)

b)

# FIG 8a

$$\gamma_0 = -0.671875$$
$$\gamma_1 = -0.125$$
$$\gamma_2 = -0.40625$$
$$\gamma_3 = +0.8671875$$

8 kHz    24 kHz

# FIG 8b